# EUROPÄISCHE PATENTSCHRIFT

(11) **EP 2 199 816 B1**
(45) Veröffentlichungstag und Bekanntmachung des Hinweises auf die Patenterteilung: **18.02.2015**
(21) Anmeldenummer: 09179855.3
(22) Anmeldetag: 18.12.2009
(51) Int. Cl.: G01R 33/30

(54) **Automatische Transportvorrichtung für NMR-Messproben, Kryomagnetsystem mit automatischer Transportvorrichtung und Verfahren zum Befördern einer NMR-Messprobe**
Automatic transport device for NMR measuring samples, cryomagnetic system with automatic transport device and method for transporting a NMR measuring sample
Dispositif de transport automatique pour échantillons de mesure NMR, système de cryo-aimant doté d'un dispositif de transport automatique et procédé de transport d'un échantillon de mesure NMR

(30) Priorität: 19.12.2008 DE 102008063703
(43) Veröffentlichungstag der Anmeldung: 23.06.2010
(73) Patentinhaber: Bruker BioSpin AG, 8117 Fällanden (CH)
(72) Erfinder: de Vries, Jonathan, 8052, Zürich (CH); Baumann, Daniel Guy, 8057, Zürich (CH); Schett, Oskar, 8610, Uster (CH); Maas, Werner, Merrimac, MA 01921 (US)
(74) Vertreter: Kohler Schmid Möbus

(56) Entgegenhaltungen:
- EP-A1- 1 895 314
- DE-A1- 3 729 819
- JP-A- 2006 234 539
- JP-U- 62 092 461

## Beschreibung

Die Erfindung betrifft eine Transportvorrichtung zum Befördern eines Transportgutes zwischen einem Eingabepunkt, an dem das Transportgut in die Transportvorrichtung eingesetzt und entnommen werden kann, und einem Zuführungspunkt, an dem das Transportgut einem RT-Rohr eines Kryostaten zugeführt werden kann, wobei das Transportgut eine NMR Messprobe und einen Probenhalter umfasst, wobei der Eingabepunkt zum Zuführungspunkt sowohl horizontal als auch vertikal beabstandet ist, und wobei ein Transportrohr zum pneumatischen Befördern des Transportgutes innerhalb des Transportrohrs von einem ersten Transferpunkt am unteren Ende des Transportrohrs zu einem zweiten Transferpunkt am oberen Ende des Transportrohrs vorgesehen ist.

Eine solche Vorrichtung ist bekannt aus DE 3729819 C2 [1].

### Hintergrund der Erfindung

Im Laufe der Weiterentwicklung der NMR-Spektrometer seit den 1950er Jahre sind diese sehr viel leistungsfähiger geworden. Sie arbeiten praktisch immer mit einem schnellen Rechner, um vor allem die Methode der schnellen FourierTransformierten NMR-Spektroskopie (= FFT-NMR) anwenden zu können, und sie arbeiten zudem fast ausschließlich mit supraleitenden Magnetsystemen mit Feldern bis zu 20 Tesla.

Der eingebaute Rechner erlaubt aber nicht nur die schnelle FFT auszuführen, sonder kann auch für Automatisierungsaufgaben eingesetzt werden, wie z.B. den automatischen Transport der NMR-Messprobe von einem für den Benutzer gut zugänglichen Ort bis zum magnetischen Zentrum des supraleitenden Magneten und wieder zurück. Ein solcher automatischer Transport ist besonders bei Hochfeld-Magneten mit Feldern von 16T bis 20T sehr zweckmäßig, da diese Magnetsysteme über 2.50m hoch sein können, und die NMR-Messprobe im oberen Bereich des Magnetsystems eingeführt werden muss.

Eine bekannte Transportvorrichtung ist der «SampieJet» [3] der Firma Bruker. Bei dieser handelt es sich um einen Sample-Automaten mit einer Magazinkapazität von bis zu 480 NMR-Probengläschen die dem Automatenmagazin in 5 Kassetten ä 96Stk. Probengläschen zusammen mit bis zu 47 Transportgüter von Hand zugeführt werden können. Die Transportgüter können der NMR-Messung einzeln, in wahlweiser oder sequentieller Reihenfolge, zugeführt werden. Der Sample-Automat kann NMR-Probengläschen (20) mit Probenhalter (19) zu Transportgütern (18) vereinen und diese anschließend der NMR-Messung zuführen oder aber Transportgüter (18) direkt und ohne weitere Manipulationen der NMR-Messung zuführen.

Eine weitere bekannte Transportvorrichtung ist der «BACS» [4] der Firma Bruker. Es ist dies ein Sample-Automat mit Kettenrundlauf, der mit einer Magazinkapazität von 60 oder 120 Transportgütern erhältlich ist. Die Transportgüter können der NMR-Messung einzeln, in wahlweiser oder sequentieller Reihenfolge, zugeführt werden.

Eine weitere bekannte Transportvorrichtung ist der «NMR Case» [5] der Firma Bruker. Dabei handelt es sich um einen Sample-Karussellautomaten, der über eine Magazinkapazität von 24 Transportgütern verfügt. Die Transportgüter können der NMR-Messung einzeln und nur in sequentieller Reihenfolge, zugeführt werden.

Eine weitere bekannte Transportvorrichtung ist der «Sample Changer» ASC [6] der Firma Jeol. Bei diesem handelt es sich um einen Sample-Karussellautomaten, der mit Magazinkapazitäten von 8, 16, oder 64 Transportgüter erhältlich ist. Die Transportgüter können der NMR-Messung einzeln, in wahlweiser oder sequentieller Reihenfolge, zugeführt werden.

Eine weitere bekannte Transportvorrichtung ist der «Carousel Autosampler» [7] der Firma Varian. Bei diesem handelt es sich um einen Sample-Automaten, der über ein Magazin mit einer Aufnahmekapazität von 9 Transportgütern verfügt. Die Transportgüter können der NMR-Messung einzeln, in wahlweiser oder sequentieller Reihenfolge, zugeführt werden.

Nachteilig an den oben beschriebenen Transportvorrichtungen ist der Umstand, dass der Benutzer für die Transportgutbestückung des Automaten (und in [3] für die Kassettenbestückung bzw. in [5] für den Wechsel der Karussellkassette) in den Höhenbereich des oberen Endes des RT-Rohrs gelangen muss, wofür bei größeren Magneten Hilfsmittel wie Leitern, Treppen oder gar Gerüste in Anspruch genommen werden müssen. Derartige Hilfsmittel sind jedoch umständlich und zum Teil sehr kostspielig.

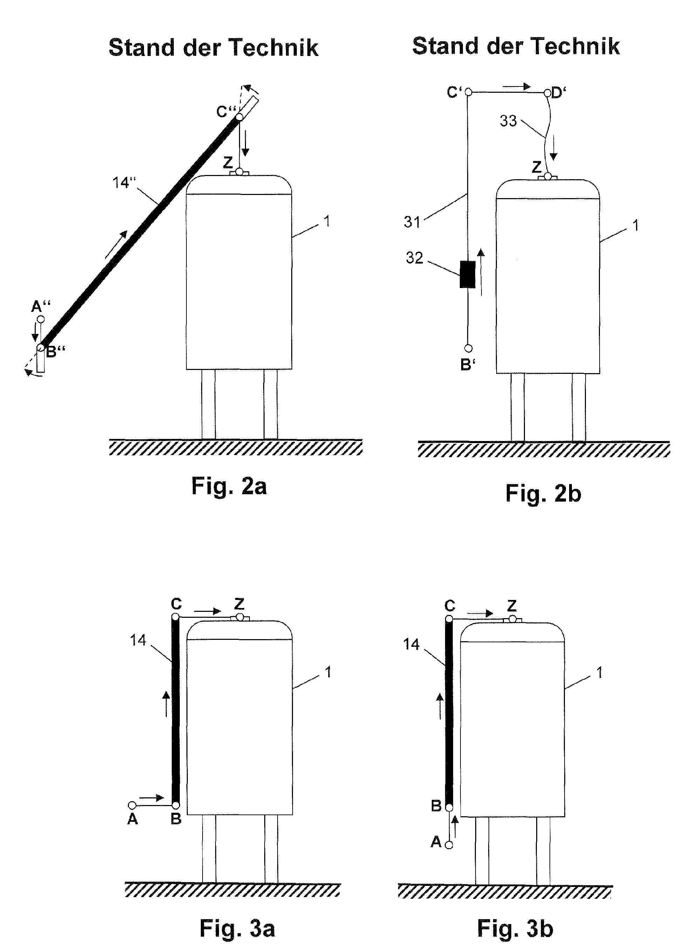

Eine automatische Transportvorrichtung ist aus [2] bekannt. («SampleRail» der Firma Bruker) und in **Fig. 2b** schematisch dargestellt. Die bekannte Transportvorrichtung befördert das Transportgut von einem dem Benutzer gut zugänglichen Ort (Punkt **B'**) über Punkte **C'** und **D'** zu einem Zuführungspunkt **Z,** von dem aus das Transportgut in das RT-Rohr eines Kryostaten **1** eingeführt werden kann, und zurück. Bei dieser Transportvorrichtung wird ein Höhenunterschied zwischen den Punkten B' und C' mittels einer pneumatisch angetriebenen Linearachse **31** bewältigt. Die Linearachse 31 umfasst eine Linearführung mit integriertem pneumatischem Antrieb, der einen Kolben mit mechanisch verbundenem Mitnehmer, an dem die zu bewegenden Teile angebracht werden können, einen Zylinder und entsprechende Dichtungselemente umfasst. Das Transportgut befindet sich dabei in einem Transportbehälter **32,** der beim Punkt C' vom Schlitten der vertikal angeordneten Linearachse **31** ausgekuppelt und durch Einkuppeln am Schlitten einer horizontal angeordneten Linearachse übergeben wird. Dieser befördert dann das Transportgut zum Punkt **D'.** Zwischen Punkt D' und zuführungspunkt Z befindet sich ein flexibler Schlauch **33,** um das Transportgut 18 auch dann führen zu können, wenn sich der schwingungsgedämpfte und dadurch "schwimmend" gelagerte Kryostat durch Abdampfen des Kältemittels hebt oder neigt.

Nachteilig an der Transportvorrichtung aus [2] ist, dass für die Beförderung des Transportgutes in horizontaler- sowie vertikaler Richtung ein kostspieliger Transportbehälter 32 mit kostspieliger Kupplüngsadaption zur Aufnahme des Transportbehälters an der horizontalen und vertikalen Linearachse benötigt wird. Da der Transportbehälter 32 während der vertikalen Bewegung nicht in der Linearachse 31 eingeschlossen ist, sondern außerhalb und entlang der als Zylinders ausgebildeten Linearachse bewegt wird, müssen im Bewegungsbereich des Benutzers darüber hinaus kostspielige Sicherheitsvorkehrungen dafür sorgen, dass auf der einen Seite das Transportgut, auf der anderen Seite das Bedienerpersonal keinen Schaden erleiden kann.

Der Hub der pneumatischen Linearachse 31 ist abhängig von Raumhöhe und Kryostatengröße. Anpassungen der Linearachslänge 31 sind auf Grund komplexer Dichtungen, erforderlichem Werkzeug etc. vor Ort nicht wirtschaftlich auszuführen, weshalb vor jeder Neumontage aufwändige Arbeitsvorbereitungen und eine kundenspezifische Materialbeschaffung notwendig ist.

Die aus [2] bekannte Transportvorrichtung ist selbsttragend (in Fig. 2b nicht dargestellt) und sehr massiv. Durch das daraus resultierende Eigengewicht darf es nicht fest mit dem Kryostaten 1 verbunden werden (Kippgefahr). Durch den Umstand, dass diese Transportvorrichtung nicht fix mit dem schwingungsgedämpften Kryostaten 1 verbunden ist und selbst keine aktive Schwingungsdämpfung besitzt, hat man sich mit dem flexiblen Schlauch 33 zwischen Punkt D' und Punkt Z (siehe Fig. 2b) beholfen. Dieser Schlauch 33 vermag jedoch nicht alle Schwingungen zu dämpfen und schnürt sich beim Senken des Kryostaten 1 ein (dies ist der Fall, wenn Kryostaten 1 mit Helium oder Stickstoff befüllt werden). Durch das Einschnüren des Schlauches 33 verringert sich dessen Durchmesser, was immer wieder dazu führt, dass das Transportgut darin verklemmt.

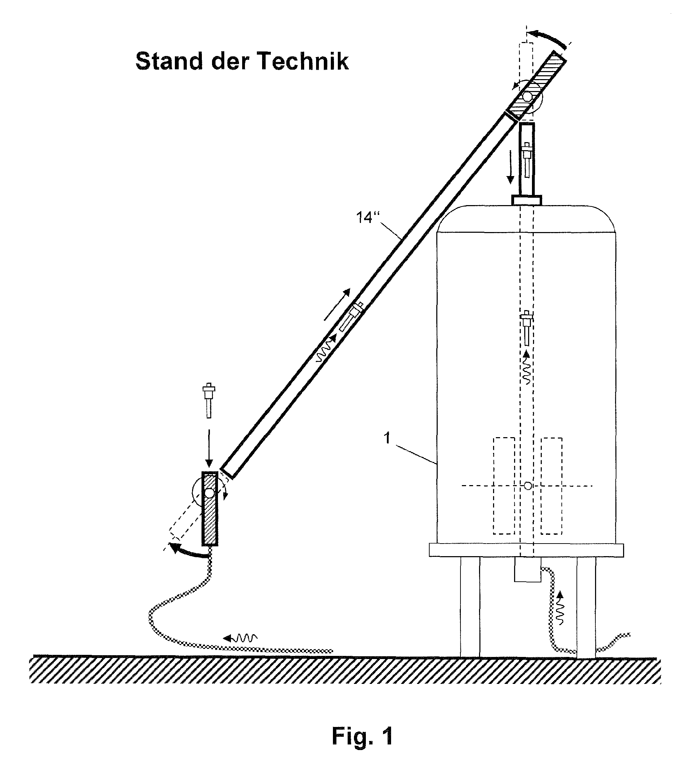

Eine Transportvorrichtung gemäss der Präambel von Anspruch 1 ist aus JP-A-2006 234539 bekannt.
[1] beschreibt eine pneumatisch arbeitende Transportvorrichtung bestehend aus einem schräg angeordneten Rohr (Schrägrohr 14"), das von einem Punkt B" zu einem Punkt C" (Fig. 2a) verläuft, und in welchem die in einem Probenhalter befindliche NMR-Messprobe mittels Druckgas auf oder ab befördert werden kann (Fig. 1). En Eingabepunkt A" befindet sich an einem vom Benutzer leicht zugänglichen Ort und ein Punkt C" nahe der oberen Öffnung des Raumtemperatur-Rohrs (= RT-Rohr), das zum NMR-Kryostaten 1 gehört.
   Nachteile an der Transportvorrichtung aus [1] ist, dass durch die Lage des Schrägrohres 14" das Transportgut und damit die darin enthaltenen hochsensiblen Proben aus der senkrechten Achse gedreht werden. Durch die Schräglage des Rohres 14" und die Eigengewichtskraft des Transportgutes entsteht Reibung zwischen der inneren Rohrmantelfläche und dem Probenhalter. Je nach Winkellage des Schrägrohres 14" und der Schwerpunktlage des Transportgutes (dieser ändert sich in Abhängigkeit zum Probenfüllstand, Durchmesser von NMR-Probengläschen und Probenhaltertyp) neigt das Transportgut in unterschiedlicher Art und Weise dazu, sich zwischen der inneren Mantelfläche des Schrägrohres 14" zu verklemmen. Besonders gravierend kommen diese Verklemmungseffekte zwischen den Übergängen des oberen und unteren Schwenkrohrs und dem Schrägrohr 14"zum Tragen, in zunehmendem Maße je mehr sich die Winkellage des Schrägrohrs 14" der horizontalen Lage nähert. Zudem wird die benötigte Raumhöhe umso größer, je näher zum Kryostaten 1 der vom Bedienerpersonal gut zugängliche Ort gewünscht wird, und je größer der Durchmesser des Kryostaten 1 ist. Fig. 2a zeigt, wie diese Forderungen dazu führen, dass die Strecke zwischen Punkt C" und Zuführungspunkt Z und damit auch die erforderliche Raumhöhe immer größer wird. Darüber hinaus können, wenn das Schrägrohr 14" in der Tischplatte einer Konsole endet und mit dieser fix verbunden ist (siehe Dokument [1], Fig.2, Element 65, Beschreibung Abschnitt 35), mechanische Schwingungen von der Tischplatte einer Konsole auf die Transportvorrichtung und von dieser auf den Kryostaten 1 übertragen werden, was jedoch zu vermeiden ist.

### Aufgabe der Erfindung

Es ist daher Aufgabe der Erfindung, eine kostengünstige Transportvorrichtung für den Transport eines Transportgutes zum oberen Ende eines RT-Rohrs eines Kryomagnetsystems vorzuschlagen, die einerseits kompakt ist und gleichzeitig einen zuverlässigen Transport von Proben gewährleistet.

### Kurze Beschreibung der Erfindung

Diese Aufgabe wird erfindungsgemäß dadurch gelöst, dass das Transportrohr ausgebildet ist zur direkten pneumatischen Beförderung des Transportgutes ohne Verwendung eines Mitnahmeschlittens, so dass das Transportgut innerhalb des Transportrohres selbst als Kolben und die innere Mantelfläche des Transportrohres als Zylinder wirkt, dass ein erster Transportbehälter mit einer oberen Öffnung zur Aufnahme des Transportgutes und mit einer unteren Öffnung zum Zuführen eines Druckgases und eine erste Transfervorrichtung zum Befördern des ersten Transportbehälters zwischen dem Eingabepunkt und dem ersten Transferpunkt vorgesehen sind,
und dass ein zweiter Transportbehälter zur Aufnahme des Transportgutes vorgesehen ist und zwischen dem zweiten Transferpunkt und dem Zuführungspunkt eine zweite Transfervorrichtung zum Befördern des zweiten Transportbehälters zwischen dem zweiten Transferpunkt und dem Zuführungspunkt angeordnet ist.

Das Transportgut wird am Eingabepunkt in den ersten Transportbehälter eingeführt, mittels der ersten Transfervorrichtung vom Eingabepunkt zum ersten Transferpunkt bewegt, mittels Druckgas aus dem ersten Transportbehälter gehoben und innerhalb des Transportrohrs hinauf in den über dem zweiten Transferpunkt C befindlichen zweiten Transportbehälter befördert. Mit Hilfe des zweiten Transportbehälters wir das Transportgut vom zweiten Transferpunkt zum Zuführungspunkt befördert, von wo aus das Transportgut in den im RT-Rohr befindlichen Messraum transferiert werden kann. Ebenso kann das Transportgut wieder vom Messraum zum Eingabepunkt befördert werden.

Bei der erfindungsgemäßen Transportvorrichtung ist keine Neigung der Achse des Transportgutes erforderlich, wodurch das Transportgut immer in einer senkrechten Stellung bleiben kann. Die Senkrechtstellung des pneumatisch arbeitenden Transportrohrs verhindert auf eine elegante Art eine Verklemmung des Transportgutes, ohne dass die seit vielen Jahren erfolgreich verwendete Form des Probenhalters («Spinner») geändert werden muss.

Das Transportgut wird mit Hilfe des Druckgases direkt und auf einfache Weise im Transportrohr befördert, ohne dass zur Überwindung des vorhandenen Höhenunterschiedes ein zusätzlicher, komplizierter Mitnahmeschlitten samt Antrieb erforderlich ist, der den Transportbehälter samt Transportgut aufnehmen, befördern und anschließend wieder abgeben kann.

Da das Transportgut innerhalb des Transportrohrs selbst als Kolben und die innere Mantelfläche des Transportrohrs als Zylinder wirkt, werden keine weiteren Elemente wie bei Verwendung massiver pneumatischer Zylinder mit Mitnahmeschlitten und Führung benötigt. Hierdurch ist es möglich, die erfindungsgemäße Transportvorrichtung so auszulegen, dass sie ausschließlich an dem Kryostaten befestigt werden kann, so dass die Übertragung von Schwingungen von der Umgebung auf den Kryostaten minimiert werden, ohne dass zusätzliche Maßnahmen zur Schwingungsdämpfung vorgesehen werden müssen.

### Vorteilhafte Ausführungsformen

Vorzugsweise umfasst die erste Transfervorrichtung eine Führungsschiene, entlang der der erste Transportbehälter verfahrbar ist.

Alternativ hierzu kann die erste Transfervorrichtung einen um eine Achse drehbaren Schwenkarm umfassen, der zur Aufnahme des ersten Transportbehälters und zur Beförderung des ersten Transportbehälters mittels einer Drehbewegung des Schwenkarms vom Eingabepunkt zum ersten Transferpunkt geeignet ist.

Eine weitere alternative Ausführungsform sieht vor, dass die erste Transfervorrichtung ein um eine Rotationsachse drehbares Karussell umfasst, das eine Vielzahl von in einem Kreis, dessen Mittelpunkt sich auf dieser Rotationsachse befindet, angeordneten ersten Transportbehältern umfasst, wobei die Transportbehälter durch eine Drehbewegung des Karussells vom Eingabepunkt zum ersten Transferpunkt verfahren werden können. Auf diese Weise können in kurzen Zeitintervallen Transportgüter befördert werden, ohne dass zusätzliche Eingriffe notwendig sind.

Die zweite Transfervorrichtung umfasst vorzugsweise eine Führungsschiene, entlang der der zweite Transportbehälter verfahrbar ist.

Besonders vorteilhaft ist es, wenn das Transportrohr eine vertikale Symmetrieachse aufweist und sowohl der erste Transferpunkt als auch der zweite Transferpunkt auf der Symmetrieachse des Transportrohrs angeordnet ist. Durch Positionierung des Transportgutes auf der Symmetrieachse des Transportrohrs wird eine optimale Beförderung des Transportgutes durch das Transportrohr gewährleistet.

Vorzugsweise weist der erste Transportbehälter eine obere Öffnung zur Aufnahme des Transportgutes auf, die einen Durchmesser hat, der gleich dem Innendurchmesser des Transportrohrs ist. Hierdurch wird die Übergabe des Transportgutes zwischen dem ersten Transportbehälter und dem Transportrohr erleichtert.

Ebenso ist es vorteilhaft, wenn der zweite Transportbehälter eine untere Öffnung zur Aufnahme des Transportgutes aufweist, die einen Durchmesser hat, der gleich dem Innendurchmesser des Transportrohrs ist.

Um eine einfache Handhabung zu gewährleisten ist es von Vorteil, wenn sich der Eingabepunkt auf einer Höhe über einem horizontalen Bodenniveau befindet, die vom Benutzer gut zugänglich ist, insbesondere auf Brusthöhe eines Menschen.

Eine besonders bevorzugte Ausführungsform der erfindungsgemäßen Transportvorrichtung sieht vor, dass der zweite Transferpunkt horizontal neben dem Zuführpunkt angeordnet ist. Auf diese Weise wird eine minimale Bauhöhe realisiert.

Je nachdem wie die räumlichen Bedingungen sind, sind unterschiedliche Anordnungen des Eingabepunkts vorteilhaft: So kann der Eingabepunkt bspw. vertikal unter dem ersten Transferpunkt angeordnet sein.

Alternativ hierzu ist es auch möglich, dass der Eingabepunkt horizontal neben dem ersten Transferpunkt liegt.

Bei einer besonderen Ausführungsform der erfindungsgemäßen Transportvorrichtung ist ein Druckgaszuführungselement vorgesehen, welches vertikal unterhalb des ersten Transferpunkts angeordnet ist und einen Abstand zu diesem besitzt, der so gewählt ist, dass der erste Transportbehälter gerade noch, vorzugsweise berührungslos, zwischen dem unteren Ende des Transportrohrs und dem oberen Ende des Druckgaszuführungselementes Platz hat, wobei das Druckgaszuführungselement eine zum unteren Ende des Transportrohrs gerichtete Öffnung aufweist und mittels einer Druckgasleitung mit einem Druckgasgenerator verbunden ist. Mittels des Druckgaszuführungselements kann Druckgas durch den Transportbehälter geleitet werden, ohne dass ein direkter Anschluss an den Transportbehälter benötigt wird. Der Transportbehälter kann somit auch problemlos über weitere Entfernungen zwischen Eingabepunkt und erstem Transferpunkt befördert werden, ohne eine entsprechend lange Druckgasleitung vorzusehen.

Um eine optimale Druckgaszuführung in das Transportrohr zu realisieren, ist es vorteilhaft, wenn die Öffnung des Druckgaszuführungselements bezüglich des Transportrohrs koaxial ausgerichtet ist.

Vorzugsweise ist im Betriebszustand das Druckgaszuführungselement an der der Öffnung entgegen gesetzten Seite mit der Druckgasleitung gasdicht verbunden. Somit wird ein vertikal nach oben gerichteter Gasstrom erzeugt.

Eine andere Ausführungsform sieht vor, dass eine Druckgasleitung im Betriebszustand gasdicht mit der unteren Öffnung des ersten Transportbehälters verbunden ist. Dies ist insbesondere vorteilhaft, wenn der Transportbehälter nur über kleine Strecken bewegt wird. Ein zusätzliches Druckgaszuführungselement ist in diesem Fall nicht notwendig.

Die vorliegende Erfindung betrifft auch ein Kryomagnetsystem mit einem Kryostaten und einer erfindungsgemässen Transportvorrichtung, wobei der Kryostat ein durchgehendes und vertikal verlaufendes RT-Rohr zur Aufnahme des Transportgutes aufweist, wobei der Eingabepunkt horizontal vom Kryostaten beabstandet ist, und wobei der Zuführungspunkt oberhalb des RT-Rohrs und auf dessen Symmetrieachse liegt. Ein derartiges Kryomagnetsystem ist platzsparend und wenig störungsanfällig, da sich das Transportgut innerhalb der erfindungsgemäßen Transportvorrichtung nicht so leicht verklemmt.

Eine besonders bevorzugte Ausführungsform des erfindungsgemäßen Kryomagnetsystems sieht vor, dass die Transportvorrichtung ausschließlich mit dem Kryostaten starr verbunden ist. Auf eine zusätzliche Schwingungsdämpfung der Transportvorrichtung gegenüber der Umgebung kann somit verzichtet werden.

Vorzugsweise ist der Innendurchmesser des Transportrohrs gleich dem Innendurchmesser des RT-Rohrs. Der zweite Transportbehälter kann dann auf diesen Durchmesser optimiert werden.

Vorzugsweise ist ein Druckgasgenerator vorgesehen, der über eine Druckgasleitung mit dem RT-Rohr derart verbunden ist, dass vom Bereich des magnetischen Zentrums her Druckgas zum oberen Ende des RT-Rohrs hin strömen kann. Das Druckgas kann bspw. am oberen Ende des RT-Rohrs in einen vom RT-Rohr getrennten Gaskanal eingeleitet, im Bereich des magnetischen Zentrums umgelenkt werden und anschließend innerhalb des RT-Rohrs zu dessen oberen Ende hin strömen.

Ein Transportbehälter zur Verwendung in einer oben beschriebenen Transportvorrichtung besitzt eine obere Öffnung zur Aufnahme eines Transportgutes umfassend einen Probenhalter und eine NMR-Messprobe, und eine entgegengesetzt angeordnete untere Öffnung zum Zuführen eines Druckgases.

Vorzugsweise weist der zweite Transportbehälter eine obere Entlüftungsöffnung, eine entgegengesetzt angeordnete untere Öffnung zur Aufnahme eines Transportgutes, welches einen Probenbehälter und eine NMR-Messprobe umfasst, und eine aktivierbare und deaktivierbare Haltevorrichtung, die im nicht aktivierten Zustand das Herunterfallen des Transportgutes verhindert und im aktivierten Zustand das Transportgut freigibt.

Vorzugsweise umfasst die Haltevorrichtung einen Arretierbolzen, der in horizontaler Richtung verschiebbar ist. Dies stellt eine einfache, sichere und wenig störungsanfällige Möglichkeit dar, das Transportgut zu sichern.

Die Erfindung betrifft auch ein Verfahren zum Befördern eines Transportgutes zwischen einem Eingabepunkt und einem Zuführungspunkt, an dem das Transportgut einem RT-Rohr des Kryostaten zugeführt werden kann, mit einer oben beschriebenen Transportvorrichtung, wobei
- am Eingabepunkt das Transportgut in einen oben beschriebenen ersten Transportbehälter eingeführt wird,
- der erste Transportbehälter vom Eingabepunkt zum ersten Transferpunkt bewegt wird,
- am unteren Ende des ersten Transportbehälters eine erste Druckgaszufuhr eingeschaltet wird, wodurch das Transportgut aus dem ersten Transportbehälter gehoben und innerhalb des Transportrohrs hinauf in einen am zweiten Transferpunkt befindlichen oben beschriebenen zweiten Transportbehälter befördert wird,

- das Transportgut im zweiten Transportbehälter arretiert wird,
- die erste Druckgaszufuhr ausgeschaltet und das Transportgut mit Hilfe des zweiten Transportbehälter vom zweiten Transferpunkt zum Zuführungspunkt befördert wird,
- eine zweite Druckgaszufuhr in den Bereich des magnetischen Zentrums (3), eingeschaltet wird, so dass sich im RT-Rohr ein Gaskissen bildet,
- das Transportgut aus dem zweiten Transportbehälter freigegeben wird, wodurch das Transportgut auf das im RT-Rohr entstandene Gaskissen fällt und so lange auf diesem nach unten in einen Messraum innerhalb des RT-Rohrs befördert wird, bis es auf einem Anschlag aufliegt.

Vorzugsweise wird nach der Ankunft des Transportgutes im Messraum die zweite Druckgaszufuhr ausgeschaltet und eine Magnetresonanzmessung, insbesondere NMR-Spektroskopie oder ESR, durchgeführt.

Vorzugsweise wird das Transportgut auf dem gleichen Weg aus dem Kryostaten heraus zum Eingabepunkt zurück befördert, wobei nach der MR-Messung
- die zweite Druckgaszufuhr wieder eingeschaltet und das Transportgut auf dem Gaskissen in den über dem Zuführungspunkt befindlichen zweiten Transportbehälter zurück befördert wird,
- das Transportgut im zweiten Transportbehälter arretiert, und die zweite Druckgaszufuhr wieder ausgeschaltet wird,
- das Transportgut im zweiten Transportbehälter vom Zuführungspunkt (Z) zurück zum zweiten Transferpunkt befördert wird,
- die erste Druckgaszufuhr eingeschaltet wird, so dass sich im Transportrohr ein Gaskissen bilden kann,
- das Transportgut aus dem zweiten Transportbehälter freigegeben wird, so dass das Transportgut auf das Gaskissen fällt und auf diesem bis zum ersten Transferpunkt und in den darunter befindlichen ersten Transportbehälter befördert wird, und
- die erste Druckgaszufuhr wieder abgeschaltet und das im ersten Transportbehälter befindliche Transportgut vom ersten Transferpunkt wieder zurück zum Eingabepunkt befördert wird.

Besonders vorteilhaft ist es, wenn zum Arretieren des Transportguts im zweiten Transportbehälter ein Arretierbolzen in den zweiten Transportbehälter eingeführt wird, der ein Herunterfallen des Transportgutes verhindert, und dass zum Freigeben des Transportguts der Arretierbolzen wieder zurückgestellt wird.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der in den Patentansprüchen definierten Erfindung.

### Zeichnung und detaillierte Beschreibung der Erfindung

Es zeigen:
- Fig.1: Schematisch dargestelltes Funktionsprinzip einer ersten Transportvorrichtung aus dem Stand der Technik nach [1];
- Fig.2a: Schematisch dargestelltes Ablaufprinzip der Transportvorrichtung aus dem aus Fig. 1;

- Fig.2b: Schematisch dargestelltes Ablaufprinzip einer zweiten Transportvorrichtung aus dem Stand der Technik nach [2];
- Fig.3a: Schematisch dargestelltes Ablaufprinzip der erfindungsgemäßen Vorrichtung, bei der das Transportgut mittels einer horizontalen Verschiebung dem Transportrohr zugeführt wird;
- Fig.3b: Schematisch dargestelltes Ablaufprinzip der erfindungsgemäßen Vorrichtung, bei der das Transportgut mittels einer vertikalen Verschiebung dem Transportrohr zugeführt wird;
- Fig.4: Schematische Seitenansicht einer ersten Ausführungsform bei der das Transportgut mittels linearer und horizontaler Bewegungen automatisiert zwischen einem dem Bedienungspersonal gut zugänglichen Ort und dem oberen Ende des RT-Rohrs eines NMR-Kryostaten hin- und her befördert wird;
- Fig.5a: Schematische Seitenansicht einer zweiten Ausführungsform der erfindungsgemäßen Transportvorrichtung, bei der das Transportgut mittels einer horizontalen Schwenkbewegung dem Transportrohr zugeführt wird;
- Fig.5b: Schematisch Darstellung eines Schwenkarms mit Transportbehälter von oben;
- Fig.6a: Schematische Seitenansicht einer dritten Ausführungsform der erfindungsgemäßen Transportvorrichtung , bei der ein Transportgut oder mehrere Transportgüter aus einer Karussell-Kassette in wahlweiser oder sequentieller Reihenfolge mittels horizontaler Bewegung zugeführt werden können;
- Fig.6b: Schematische Darstellung des Karussells mit Transportbehälter von oben;
- Fig.7a: Schematische Schnittdarstellung des unteren Bereichs des Transportrohrs, die aufzeigt, wie ein Transportbehälter samt zugeführtem Transportgut mittels horizontaler Bewegung in Deckung (Flucht) zum Transportrohr und zum Druckgaszuführungselement mit angebrachter Druckgasleitung gebracht wird;
- Fig.7b: Schematische Schnittdarstellung des unteren Bereichs des Transportrohrs, die aufzeigt, wie sich ein Transportbehälter aus Fig. 7a in Deckung (Flucht) zum Transportrohr und zum Druckgaszuführungselement mit angebrachter Druckgasleitung befindet;
- Fig.7c: Schematische Schnittdarstellung des unteren Bereichs des Transportrohrs, die aufzeigt, wie ein Transportgut aus Fig. 7b durch das aus dem vom Druckgaszuführungselement her mit Druckgas durchströmten und mit dem Transportrohr in Deckung (Flucht) gebrachten Transportbehälter in das Transportrohr befördert wird;
- Fig.8a: Schematische Schnittdarstellung des unteren Bereichs des Transportrohrs, die aufzeigt, wie ein Transportbehälter mit angebrachtem Druckgasschlauch, der mittels vertikal angeordneter Führungsvorrichtung in Deckung (Flucht) zum Transportrohr geführt wird, mit einem Transportgut bestückt wird;
- Fig.8b: Schematische Schnittdarstellung des unteren Bereichs des Transportrohrs, die aufzeigt, wie der Transportbehälter aus Fig.8a samt Transportgut mit einer vertikal wirkenden Kraft aus dem Anschlag am unteren Ende der Führungsvorrichtung gehoben und gegen das Transportrohr am oberen Ende der Führungsvorrichtung gedrückt wird;
- Fig.8c: Schematische Schnittdarstellung des unteren Bereichs des Transportrohrs, die aufzeigt, wie das Transportgut aus den mit Druckgas durchströmten Transportbehälter aus Fig. 8b, der mit einer vertikal wirkenden Kraft gegen das Transportrohr am oberen Ende der Führungsvorrichtung gedrückt wird und mit dem Transportrohr in Deckung (Flucht) geführt ist, in das Transportrohr befördert wird;

- Fig.9a: Schematische Schnittdarstellung des oberen Bereichs des Transportrohrs, die aufzeigt, wie ein Transportgut innerhalb des mit Druckgas durchströmten und mit dem Transportrohr deckungsgleichen (fluchtenden) Transportbehälter, den durch Krafteinwirkung entriegelten Arretierbolzen passiert hat;
- Fig.9b: Schematische Schnittdarstellung des oberen Bereichs des Transportrohrs, die aufzeigt, wie ein Transportgut innerhalb des Transportbehälters aus Fig. 9a auf dem verriegelten Arretierbolzen aufliegt;
- Fig.9c: Schematische Schnittdarstellung des oberen Bereichs des Transportrohrs, die aufzeigt, wie ein Transportgut durch die Schwerkraft den mittels Krafteinwirkung entriegelten Arretierbolzen passiert hat und demnächst die untenliegende Öffnung des Transportbehälters in Richtung deckungsgleiches Transportrohr verlassen wird, während die Fallgeschwindigkeit des Transportgutes mittels entgegenwirkenden Gasstroms kontrolliert wird;
- Fig.10a: Schematische Darstellung einer erfindungsgemäßen Transportvorrichtung mit einer standardisierten Führungsvorrichtung und einem in der Länge individuell an ein supraleitendes Niederfeld-Magnetsystem angepassten Transportrohr ; und
- Fig.10b: Schematische Darstellung einer erfindungsgemäßen Transportvorrichtung mit einer standardisierten Führungsvorrichtung und einem in der Länge individuell an ein supraleitendes Hochfeld-Magnetsystem angepasstes Transportrohr.

Bei der erfindungsgemäßen automatischen Transportvorrichtung wird ein Transportgut **18,** umfassend ein Probengläschen **20** in einem Probenhalter **19** von einem vom Benutzer gut zugänglichen Eingabepunkt **A** (Fig.3a, **b**) zu einem Zuführungspunkt **Z** befördert, der oberhalb einer durchgehende und senkrecht verlaufende Bohrung (=RT-Rohr **4**) eines Kryostaten **1** angeordnet ist. Die Beförderung des Transportgutes erfolgt in drei Transportabschnitten jeweils entweder horizontal (vom Eingabepunkt A zu einem ersten Transferpunk B und von einem zweiten Transferpunkt C zum Zuführungspunkt Z) oder vertikal (vom ersten Transferpunk B zum zweiten Transferpunk C). Der vertikale Transport wird mittels eines Transportrohrs 14 durchgeführt, innerhalb welchem das Transportgut 18 pneumatisch befördert wird.

Das Transportrohr **14** überbrückt auf elegante, ökonomische und äußerst flexible, da individuell an die örtlichen "vor Ort" Bedingungen anpassbaren Weise, den Höhenunterschied zwischen dem ersten Transferpunkt B und dem zweiten Transferpunkt C neben dem oberen Ende des RT-Rohrs 4. Durch diese Tatsache kann das Bedienerpersonal zum Wechseln der Probengläschen 20 auf Steig-Hilfsmittel wie Leitern, Treppen, Gerüste etc. verzichten, womit die Prozesssicherheit und der Bedienerkomfort steigt und das Unfallrisiko des Laborpersonals sinkt.

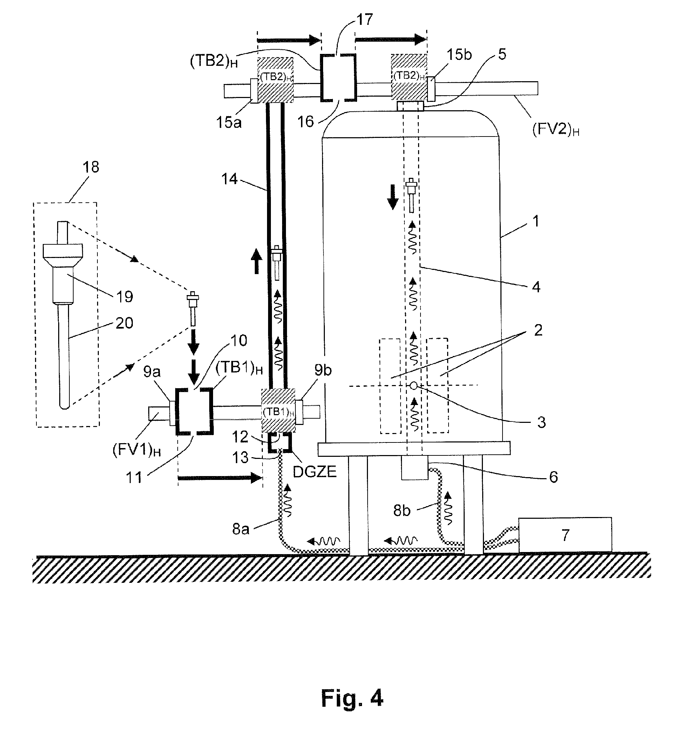

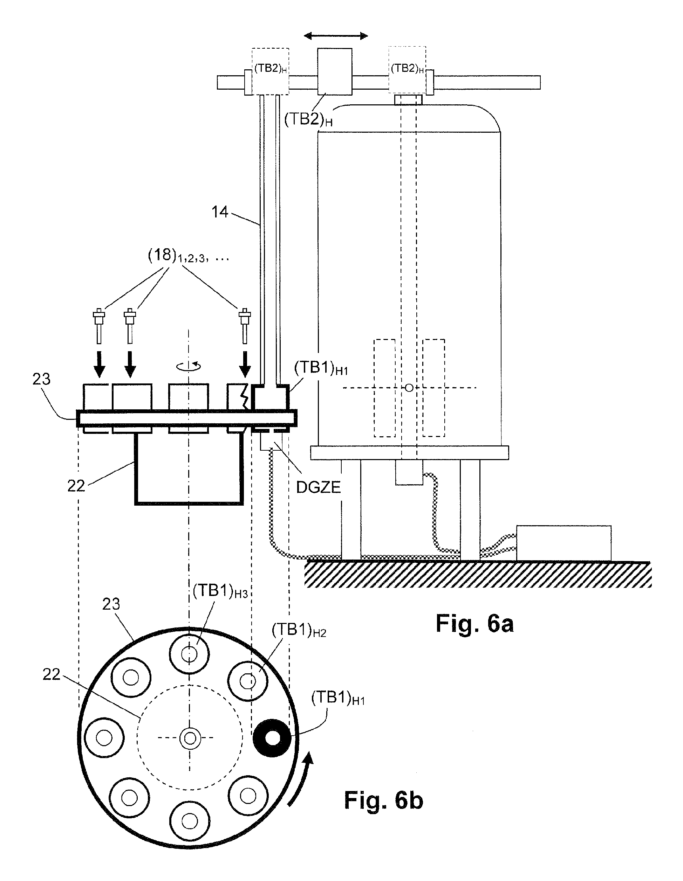

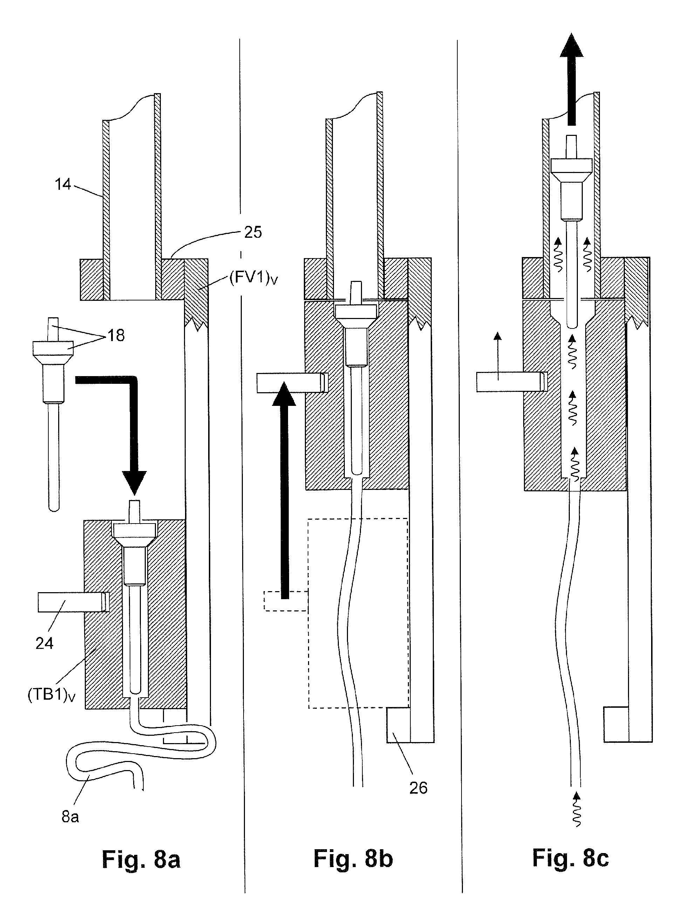

Die erfindungsgemäße Vorrichtung kann ohne weitere Hilfsmittel an dem durch das Bedienerpersonal gut zugänglichen Eingabepunkt A in der Nähe des unteren Endes des Transportrohrs 14 bequem mit Transportgütern 18 bestückt werden, die im magnetischen Zentrum **3** eines supraleitenden Magneten **2** in einem supraleitenden Magnetsystem gemessen werden sollen. Die Bestückung der automatischen Transportvorrichtung erfolgt durch das Einfügen des Transportgutes 18 in einen Transportbehälter **(TB1)**_{H}, **(TB1)**v, wie in **Fig. 4****,** **Fig.7a** und **Fig. 8a** gezeigt, und kann von Hand oder mittels handelsüblicher Greifroboter erfolgen. Fig.8a zeigt eine vorzüglich für den Handbetrieb konzipierte Variante, bei der der Eingabepunkt A unterhalb des ersten Transferpunkts B angeordnet ist. Die Transportbehälter (TB1)_{H}, (TB1)v können einzeln (Fig. 4, Fig.5a, b, Fig.7, Fig.8) oder gleichzeitig mit mehreren Transportgütern 18_{1,2,3} (Fig. 6) zum ersten Transferpunkt B transferiert werden.

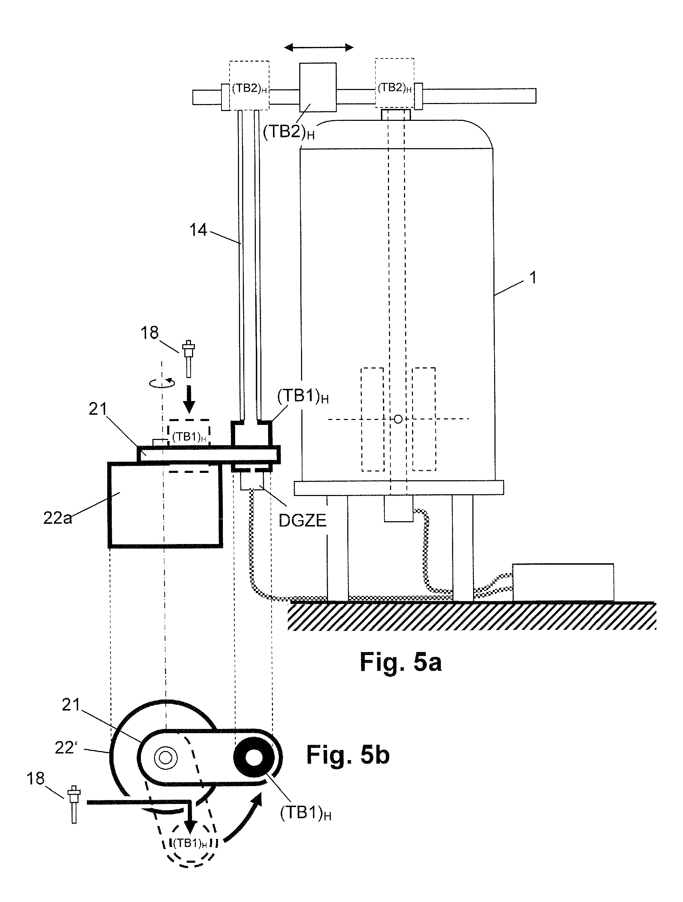

Der Transportbehälter (TB1)_{H}, (TB1)_{V} weist eine obere Öffnung **10** auf, die, sobald der Transportbehälter (TB1)_{H}, (TB1)_{V} bestückt ist, automatisch oder manuell mit Hilfe einer mittels einer Transfervorrichtung in Deckung mit der unteren Öffnung des Transportrohrs 14 gebracht werden kann, d.h. koaxial zu diesem ausgerichtet werden kann, wobei zwischen dem Transportbehälter (TB1)_{H}, (TB1)_{V} und dem Transportrohr 14 ein möglichst kleiner Abstand, vorzugsweise 0.1mm-0.3mm, entstehen sollte, der ein übermäßiges und dadurch ineffizientes Ausströmen von Druckgas, welches für die pneumatische Beförderung des Transportguts 18 benötigt wird, verhindert. (Fig.5b, Fig.6b, Fig.7b, Fig.8b).

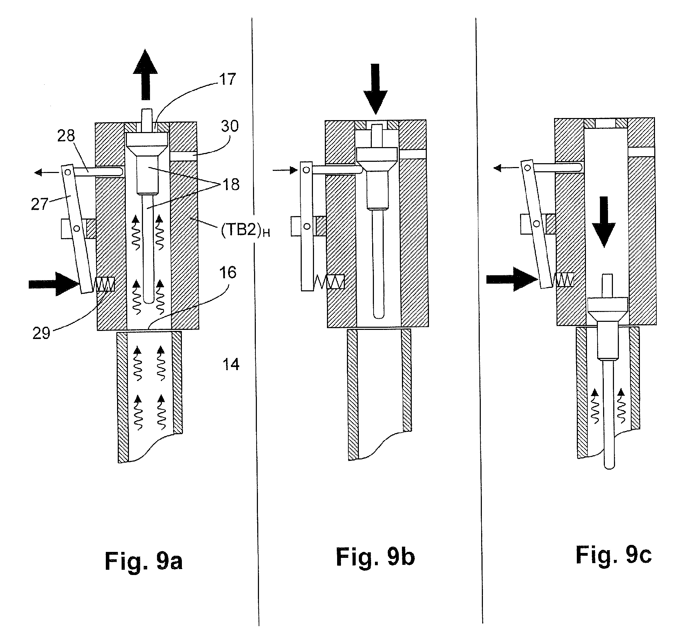

Das Transportgut 18 befindet sich jetzt in der Position zur Überführung in einen zweiten Transportbehälter **(TB2)_{H}** der sich an einem Endanschlag **15a** (Fig.4) am oberen Ende des Transportrohrs 14 befinden sollte (zweiter Transferpunkt C) und eine Öffnung **16** aufweist, die dem Transportrohr 14 zugewandt ist. Mit Hilfe mindestens eines Sensors kann nun sichergestellt werden, dass sich der obere Transportbehälter (TB2)_{H} am Endanschlag 15a befindet (d.h. dass der Transportbehälter (TB2)_{H} und das Transportrohr 14 koaxial zueinander ausgerichtet sind, so dass die untere Öffnung 16 des zweiten Transportbehälters (TB2)_{H} mit der oberen Öffnung des Transportrohrs **14** in Deckung ist). Der zweite Transportbehälter (TB2)_{H} ist im Detail in **Fig. 9a****-c** dargestellt und umfasst einen Arretierbolzen **28**, mit dem das Transportgut 18 innerhalb des zweiten Transportbehälters (TB2)_{H} fixiert werden kann. Mit Hilfe eines Hebels **27** kann der Arretierbolzen 28 aus dem Inneren (Aufnahmebohrung) des Transportbehälters (TB2)_{H} geführt werden, um das Transportgut 18 aus dem Transportrohr 14 in Empfang zu nehmen oder aus dem zweiten Transportbehälter (TB2)_{H} zu entlassen.

Zur Überführung des Transportgutes 18 vom ersten Transportbehälter (TB1)_{H} (TB1)_{V} in den zweiten Transportbehälter (TB2)_{H} wird mittels des Sensors sichergestellt, dass der Arretierbolzen 28 aus der Aufnahmebohrung des zweiten Transportbehälters (TB2)_{H} hinaus geführt wurde - entweder von Hand oder mit Hilfe einer Automatik. Nun leitet ein Druckgasgenerator **7** (Fig.4) via einer Druckgasleitung **8a** Druckgas durch eine untere Öffnung **13** eines DruckgasZuführungselements **DGZE** und von dort durch eine obere Öffnung **12** des Druckgas-Zuführungselements **DGZE** in eine untere Öffnung **11** des ersten Transportbehälters (TB1)_{H}, (TB1)vzu dem darin liegenden Transportgut 18, so dass letzteres auf einem Gaskissen empor gehoben wird, innerhalb des Transportrohrs 14 durch die untere Öffnung **16** des zweiten Transportbehälters (TB2)_{H} hindurch in den zweiten Transportbehälter (TB2)_{H} gelangt und via Sensorik ein Signal auslöst, das die Ankunft des Transportgutes 18 im zweiten Transportbehälter (TB2)_{H} meldet.

Der Sensor kann bspw. ein optischer Sensor sein, der in oder an einer Bohrung 30 des zweiten Transportbehälter (TB2)_{H} angeordnet ist. Bei Ankunft des Transportgutes 18 im zweiten Transportbehälter (TB2)_{H} wird die Bohrung 30 vom Transportgut 18 abdeckt (Fig.9a), und kann somit ein Signal im optischen Sensor auslösen. Der zweite Transportbehälter (TB2)_{H} umfasst darüber hinaus eine oben liegende Entlüftungsöffnung 17. Mit der Entlüftungsöffnung 17 und der Bohrungen 30 wird dafür gesorgt, dass das am Transportgut 18 vorbei nach oben entweichende Gas nach außen abgeleitet wird, damit kein Gasstau entsteht - dieser würde nämlich den Transportvorgang verlangsamen.

Nach erfolgter Meldung der Ankunft des Transportgutes 18 wird der Arretierbolzen 28 mit Hilfe des Hebels 27 in die Aufnahmebohrung des Transportbehälters (TB2)_{H} geführt und die Druckgaszufuhr unterbrochen. Der Arretierbolzen 28 verhindert ein Herunterfallen des Transportgutes 18, wie in Fig.9b gezeigt.

Eine Führungsvorrichtung **(FV2)_{H}** befördert den Transportbehälter (TB2)_{H} nun zum oberen Ende **5** des RT-Rohrs 4 hin (Fig.4). Sobald mittels Sensorik sichergestellt ist, dass sich der obere Transportbehälter (TB2)_{H} an einem Endanschlag **15b** befindet, d.h. deckungsgleich (koaxial) gegenüber dem RT-Rohr 4 des Kryostaten 1 ist, wird der Hebel 27 mittels Aktivierung eines Aktors betätigt, so dass der Arretierbolzen 28 nicht mehr in die Aufnahmebohrung des Transportbehälters (TB2)_{H} hinein ragt, wie in **Fig.9c** gezeigt.

Das RT-Rohr 4 ist mittels einer weiteren Druckgasleitung **8b** so mit dem Druckgasgenerator 7 verbunden, dass das Druckgas in das RT-Rohr 4 einströmen kann. In Fig. 4 ist eine Ausführungsform gezeigt, bei der das Druckgas am unteren Ende 6 des RT-Rohrs 4 (mit Verschlusszapfen) einströmt. Bevorzugt wird das Druckgas jedoch im Bereich des magnetischen Zentrums 3 eingeleitet. Der Verschlusszapfen am unteren Ende 6 des RT-Rohrs verhindert ein Ausströmen des Druckgases nach unten. Nun leitet der Druckgasgenerator 7 zur Reduzierung der Fallgeschwindigkeit so lange Druckgas durch die Druckgasleitung 8b in das RT-Rohrs 4 hinein, bis das Transportgut 18 sachte zum Zwecke einer NMR-Messung im magnetischen Zentrum 3 des supraleitenden Magneten 2 aufsetzt.

Nach der NMR-Messung wird mittels Sensorik sicher gestellt, dass sich der obere Transportbehälter (TB2)_{H} am Endanschlag 15b befindet, d.h. die untere Öffnung 16 des zweiten Transportbehälters (TB2)_{H} mit der oberen Öffnung des RT-Rohrs 4 in Deckung ist (koaxial). Ist dies sichergestellt, wird der Hebel 27 (Fig.9a), falls nicht schon zuvor erfolgt, mittels Aktivierung des Aktors betätigt, so dass der Arretierbolzen 28 nicht mehr in die Aufnahmebohrung des Transportbehälters (TB2)_{H} hinein ragt. Nun leitet der Druckgasgenerator 7 (Fig.4) so lange Druckgas durch den Verbindungsschlauch 8b in das RT-Rohr 4 des Kryostaten 1 und die Aufnahmebohrung des Transportbehälters (TB2)_{H} hindurch, bis der Probenhalter 19 des Transportgutes 18 die Bohrung 30 (Fig.9a) passiert hat. Um diesen Prozess beschleunigen zu können, ist mit der oben Entlüftungsöffnung 17 vom Transportbehälter (TB2)_{H} eine großzügige Aussparung vorhanden, durch die die vom Transportgut 18 verdrängte Luft entweichen kann. Beim Passieren der Bohrung 30 wird der Probenhalter 19 mittels Sensorik erkannt, der Aktor deaktiviert und die Druckgaszufuhr unterbrochen. Durch die Deaktivierung des Aktors drückt eine Rückstellfeder **29** den Arretierbolzen 28 zurück in die Ausgangslage innerhalb der Mantelfläche der Aufnahmebohrung des Transportbehälters (TB2)_{H}. Durch die Unterbrechung der Gaszufuhr senkt sich das Transportgut 18 so weit, bis es an dem vorstehenden Arretierbolzen 28 hängen bleibt (Fig.9b). Die Führungsvorrichtung (FV2)_{H} befördert den Transportbehälter (TB2)_{H} nun zum oberen Ende des Transportrohrs 14 (Fig.4) hin. Sobald mittels Sensorik sichergestellt ist, dass sich der obere Transportbehälter (TB2)_{H} am Endanschlag 15a befindet, d.h. deckungsgleich (koaxial) gegenüber dem Transportrohr 14 ist, wird der Hebel 27 (Fig.9c) mittels Aktivierung des Aktors betätigt, so dass der Arretierbolzen 28 nicht mehr in die Mantelfläche der Aufnahmebohrung des Transportbehälters (TB2)_{H} hinein ragt. Nun leitet der Druckgasgenerator 7 (Fig.4) zur Reduzierung der Fallgeschwindigkeit des Transportguts 18 so lange Druckgas durch den Verbindungsschlauch 8a, das Druckgas-Zuführungselement DGZE, die Aufnahmebohrung des Transportbehälters (TB2)_{H}, das Transportrohr 14 und den Transportbehälter (TB1)_{H}, (TB1)_{V} hindurch, bis das Transportgut 18 sachte im Transportbehälter (TB1) _{H}, (TB1)v aufsetzt.

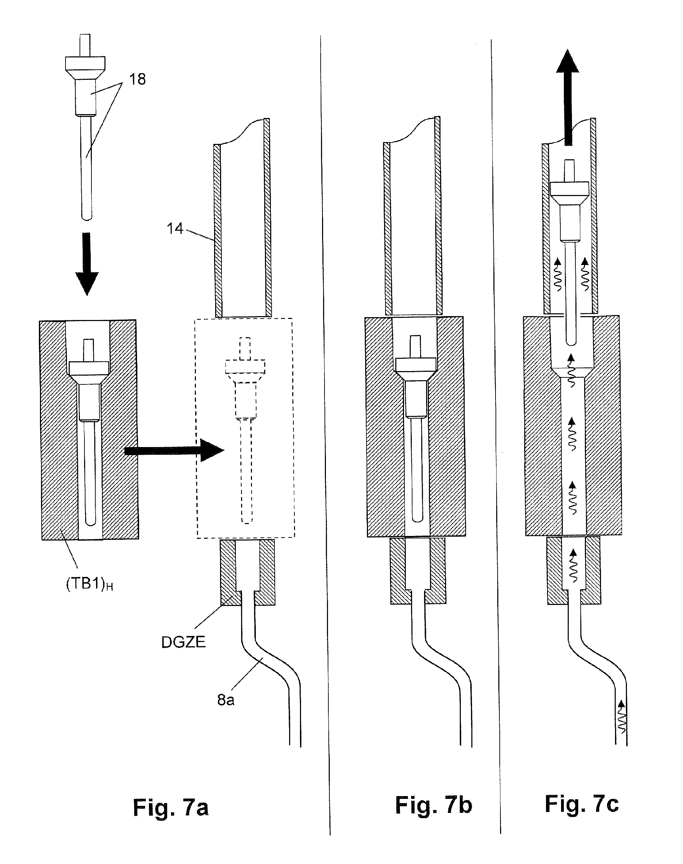

In umgekehrter Reihenfolge wie in Fig.7a-c und Fig.8a-c kann mit Hilfe der Transfervorrichtung durch Verschieben des Transportbehälters (TB1) _{H}, (TB1)v, dessen oben liegende Öffnung 10 so aus seiner Lage gegenüber dem unteren Ende des Transportrohrs 14 gebracht werden, dass die Entnahme des Transportguts 18 von Hand oder mittels eines handelsüblichen Greifroboters erfolgen und weiteren Prozessen zugeführt werden kann.

In den Fig. 4-8 sind verschiedene Ausgestaltungen der Transfervorrichtung vom Eingabepunkt A zum ersten Transferpunkt B dargestellt:
Fig. 4 zeigt die Zuführung des Transportguts 18 mittels einer horizontalen Führungsvorrichtung, hier in Form einer Führungsschiene (FV1)_{H} mit einem Endanschlag **9a** am Eingabepunkt A und einem weiteren Endanschlag **9b** unterhalb des Transportrohrs 14, wobei der Endanschlag 9b so angeordnet ist, dass die obere Öffnung des erste Transportbehälter (TB1)_{H} bei Erreichen des Endanschlags 9b koaxial mit der unteren Öffnung des Transportrohrs 14 ausgerichtet ist.
Fig. 5a, b zeigen die Zuführung des Transportguts 18 mittels eines Schwenkarms 21. Der Schwenkarm 21 ist drehbar an einer Befestigung 22 montiert und kann um eine senkrechte Achse verschwenkt werden, so dass der im Schwenkarm befindliche erste Transportbehälter (TB1)_{H} durch diese Schwenkbewegung vom Eingabepunkt A zum ersten Transferpunkt B bewegt werden kann.
Fig. 6a, b zeigen die Zuführung des Transportguts 18 mittels eines Karussells 23. Das Karussell 23 ist an einer Befestigung 22a montiert und um eine vertikale Achse rotierbar. Auf einem Kreis mit der Drehachse als Mittelpunkt sind mehrere erste Transportbehälter (TB1) _{H1}, (TB1)_{H2}, (TB1)_{H3} angeordnet, die jeweils ein Transportgut 18₁, 18₂, 18₃ aufnehmen und durch Rotation des Karussells vom Eingabepunkt A zum ersten Transferpunkt B bewegt werden können.
Fig. 8a-c zeigen eine Möglichkeit der vertikalen Zuführung des ersten Transportbehälters (TB1)vzum ersten Transferpunkt B mittels einer vertikalen Führungsvorrichtung (FV1)v. Hier ist der ersten Transportbehälters (TB1)v direkt mit der Druckgasleitung 8a verbunden. Nach Einsetzen des Transportgutes 18 in den ersten Transportbehälter (TB1)_{V} wird der erste Transportbehälter (TB1)_{V} mittels eines aus dem ersten Transportbehälters(TB1)_{V} herausragenden Bolzens 24 vertikal zum unteren Ende des Transportrohrs 14 bewegt und gegen dieses gedrückt. Die Führungsvorrichtung (FV1)_{V} umfasst eine Führungsschiene mit einem unteren Anschlag 26 und einem Flansch 25 mit dem die Führungsvorrichtung (FV1)_{V} am Transportrohr 14 befestigt ist.

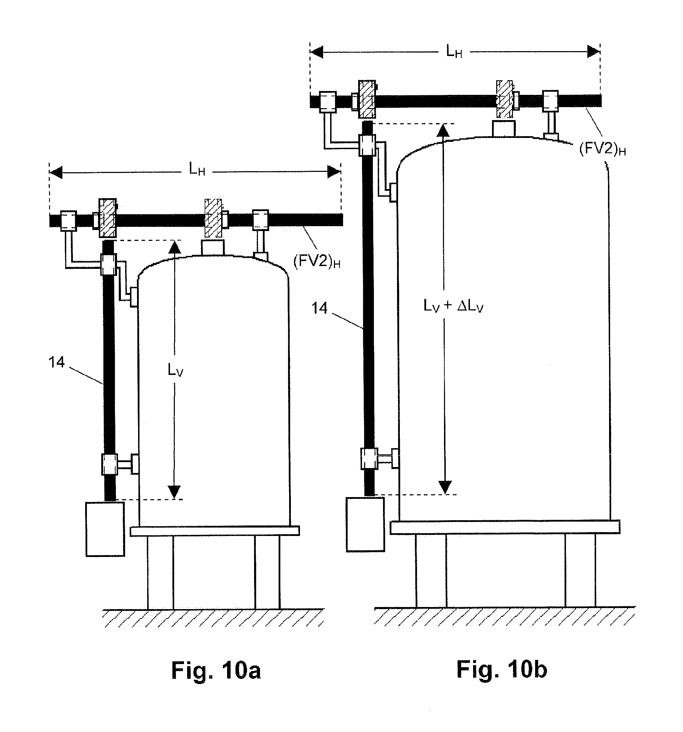

Die erfindungsgemäße Transportvorrichtung kann direkt am Kryostaten 1 befestigt werden, wie in den **Fig. 10a****, b** gezeigt. Auf diese Weise kann die Übertragung von Vibrationen aus der Umgebung minimiert werden. Fig. 10a, b zeigen auch, wie die erfindungsgemäße Transportvorrichtung an verschiedene Kryostaten angepasst werden kann.

### Bezugszeichenliste

- A, A": Eingabepunkt
- B, B', B": erster Transferpunkt
- C, C', C": zweiter Transferpunkt
- D': dritter Transferpunkt
- Z: Zuführungspunkt zum RT-Rohr des Kryostaten
- (TB1)_{H}: Transportbehälter, der sich im unteren Bereich des Transportrohrs 14 befindet und in horizontaler Richtung bewegt wird
- (TB1)_{V}: Transportbehälter, der sich im unteren Bereich des Transportrohrs 14 befindet und in vertikaler Richtung bewegt wird
- (TB1)_{H1,H2,H3}: Transportbehälter des Karussells (23)
- (FV1)_{H}: Führungsschiene, die sich im unteren Bereich des Transportrohrs 14 befindet und zur horizontalen Führung des Transportbehälters (TB1)_{H} dient
- (FV1)_{V}: Führungsvorrichtung, die sich im unteren Bereich des Transportrohrs 14 befindet und zur vertikalen Führung des Transportbehälters (TB1)_{V} dient
- (TB2)_{H}: Transportbehälter, der sich im oberen Bereich des Transportrohrs 14 befindet und in horizontaler Richtung bewegt wird
- (FV2)_{H}: Führungsvorrichtung, die sich im oberen Bereich des Transportrohrs 14 befindet und zur horizontalen Führung des Transportbehälters (TB2)_{H} dient
- DGZE: Druckgaszuführungselement zu den Transportbehältern (TB1)_{H} und (TB1)_{H1,H2,H3}
- 1: Kryostat
- 2: Supraleitender Magnet (SL-Magnet)
- 3: Magnetisches Zentrum des SL-Magneten
- 4: RT-Rohr des Kryostaten 1
- 5: Oberes Ende des RT-Rohrs 4
- 6: Unteres Ende des RT-Rohrs 4 mit Verschlusszapfen
- 7: Druckgas-Generator inkl. Steuerung
- 8a,b: Druckgasleitungen
- 9a,b: Endanschläge an der Führungsschiene (FV1)_{H} zur Begrenzung des verschiebbaren Bereichs des Transportbehälters (TB1)_{H}
- 10: Oben liegende Öffnung des Transportbehälters (TB1)_{H}, die zur Aufnahme oder Entfernung des Transportgutes 18 dient

- 11: Unten liegende Öffnung des Transportbehälters (TB1)_{H}, die zur Zuführung von Druckgas dient.
- 12: Obere Öffnung des Druckgaszuführungselements, die zur Zufuhr von Druckgas zu den Transportbehältern (TB1)_{H} und (TB1)_{H1,H2,H3,...} dient
- 13: Untere Öffnung des Druckgaszuführungselements für den Anschluss der Druckgasleitung 8a
- 14: Transportrohr zur pneumatischen Beförderung des Transportguts zwischen zwei verschiedenen Höhen-Bereichen
- 14": Schrägrohr zur pneumatischen Beförderung des Transportguts zwischen zwei verschiedenen Höhen-Bereichen
- 15a,b: Endanschläge an der zweiten Führungsvorrichtung (FV2)_{H} zur Begrenzung des verschiebbaren Bereichs des (TB2)_{H}
- 16: Unten liegende Öffnung des zweiten Transportbehälters (TB2)_{H} zur Aufnahme oder Entfernung des Transportgutes
- 17: Oben liegende Öffnung des zweiten Transportbehälters (TB2)_{H} für den Austritt des überflüssigen Druckgases
- 18: Transportgut
- 18_{1,2,3}: Mehrere Transportgüter im Karussell (23)
- 19: Probenhalter («Spinner»)
- 20: NMR-Probengläschen
- 21: Schwenkarm für den Transportbehälter (TB1)_{H}
- 22: Befestigung des Schwenkarms 21 inkl. Drehantrieb
- 22a: Befestigung des Karussells 23 inkl. Drehantrieb
- 23: Karussell mit integrierten Transportbehältern (TB1)_{H1}, (TB1)_{H2}, (TB1)_{H3}
- 24: Bolzen, um den ersten Transportbehälter (TB1)_{V} von Hand vertikal zu bewegen
- 25: Flansch am unteren Ende des Transportrohrs 14
- 26: Anschlag am unteren Ende der Führungsschiene (FV1)_{V}
- 27: Hebel zur Betätigung des Arretierbolzens 28
- 28: Arretierbolzen, um das Transportgut vom Hinunterfallen zu bewahren
- 29: Rückstellfeder des Hebels 27
- 30: Bohrung für die optische Überwachung des Transportgutes
- 31: Vertikal angeordnete Pneumatikachse, selbsttragend mit standsicherem Fundament
- 32: Spezieller ein- und auskuppelbarer Transportbehälter zur Aufnahme des Transportgutes 18, wobei dieser zwischen der horizontalen- und vertikalen Linearachse umgekuppelt werden kann
- 33: Flexibler Schlauch, in dem das Transportgut 18 zwischen den Punkten D und Z transportiert wird

### Referenzliste

[1] DE 3729819 C2 (A. Kuster)
[2] SampleRail (Bruker)
   (http://www.bruker-biospin.com/sample_rail.html)
[3] Sample Jet (BRUKER)
   (http://www.bruker-biospin.com/samplejet.html)
[4] BACS (Bruker)
   (http://www.bruker-biospin.com/bacs.html)
[5] NMR Case (Bruker)
   (http://www.bruker-biospin.com/sample_rail0.html)
[6] Sample Changer ASC (JEOL)
   (http://www.jeolusa.com/PRODUCTS/Analyticallnstruments/NuclearMagnetic Resonance/SampleChangers/tabid/389/Default.aspx)
[7] Carousel Autosampler (VARIAN)
   (http://www.varianinc.com/cgi-bin/nav?products/nmr/accessory/auto _samplers/carousel/carousel_specs&cid=KLILILKJFN)

## Patentansprüche

1. Transportvorrichtung zum Befördern eines Transportgutes (18) zwischen einem Eingabepunkt (A), an dem das Transportgut (18) in die Transportvorrichtung eingesetzt und entnommen werden kann, und einem Zuführungspunkt (Z), an dem das Transportgut (18) einem RT-Rohr(4) eines Kryostaten (1) zugeführt werden kann, wobei das Transportgut (18) eine NMR-Messprobe (20) und einen Probenhalter (19) umfasst,
wobei der Eingabepunkt (A) zum Zuführungspunkt (Z) sowohl horizontal als auch vertikal beabstandet ist,
wobei ein Transportrohr (14) zum Befördern des Transportgutes innerhalb des Transportrohrs (14) von einem ersten Transferpunkt (B) am unteren Ende des Transportrohrs (14) zu einem zweiten Transferpunkt (C) am oberen Ende des Transportrohrs (14) vorgesehen ist,
wobei das Transportrohr (14) vertikal angeordnet ist,
**dadurch gekennzeichnet,**
**dass** das Transportrohr (14) ausgebildet ist zur direkten pneumatischen Beförderung des Transportgutes ohne Verwendung eines Mitnahmeschlittens, so dass das Transportgut (18) innerhalb des Transportrohrs (14) selbst als Kolben und die innere Mantelfläche des Transportrohrs (14) als Zylinder wirkt,
**dass** ein erster Transportbehälter (TB1) mit einer oberen Öffnung zur Aufnahme des Transportgutes (18) und mit einer unteren Öffnung zum Zuführen eines Druckgases und eine erste Transfervorrichtung zum Befördern des ersten Transportbehälters (TB1) zwischen dem Eingabepunkt (A) und dem ersten Transferpunkt (B) vorgesehen sind, und
**dass** ein zweiter Transportbehälter (TB2) zur Aufnahme des Transportgutes (18) vorgesehen ist und zwischen dem zweiten Transferpunkt (C) und dem Zuführungspunkt (Z) eine zweite Transfervorrichtung zum Befördern des zweiten Transportbehälters (TB2) zwischen dem zweiten Transferpunkt (C) und dem Zuführungspunkt (Z) angeordnet ist.

2. Transportvorrichtung nach Anspruch 1, **dadurch gekennzeichnet, dass** die erste Transfervorrichtung eine Führungsschiene (FV1) umfasst, entlang der der erste Transportbehälter (TB1) verfahrbar ist.

3. Transportvorrichtung nach Anspruch 1, **dadurch gekennzeichnet, dass** die erste Transfervorrichtung einen um eine Achse drehbaren Schwenkarm umfasst, der zur Aufnahme des ersten Transportbehälter (TB1) und zur Beförderung des ersten Transportbehälters mittels einer Drehbewegung des Schwenkarms (21) vom Eingabepunkt (A) zum ersten Transferpunkt (B) geeignet ist.

4. Transportvorrichtung nach Anspruch 1, **dadurch gekennzeichnet, dass** die erste Transfervorrichtung ein um eine Rotationsachse drehbares Karussell (23) umfasst, das eine Vielzahl von in einem Kreis, dessen Mittelpunkt sich auf dieser Rotationsachse befindet, angeordneten ersten Transportbehältern (TB1) umfasst, wobei die Transportbehälter (TB1) durch eine Drehbewegung des Karussells (23) vom Eingabepunkt (A) zum ersten Transferpunkt (B) verfahren werden können.

5. Transportvorrichtung nach einem der vorhergehenden Ansprüche, **dadurch gekennzeichnet, dass** die zweite Transfervorrichtung eine Führungsschiene (FV2) umfasst, entlang der der zweite Transportbehälter (TB2) verfahrbar ist.

6. Transportvorrichtung nach einem der vorhergehenden Ansprüche, **dadurch gekennzeichnet, dass** das Transportrohr (14) eine vertikale Symmetrieachse aufweist und sowohl der erste Transferpunkt (B) als auch der zweite Transferpunkt (C) auf der Symmetrieachse des Transportrohrs (14) angeordnet ist.

7. Transportvorrichtung nach einem der vorhergehenden Ansprüche, **dadurch gekennzeichnet, dass** der erste Transportbehälter (TB1) eine obere und der zweite Transportbehälter (TB2) eine untere Öffnung zur Aufnahme des Transportgutes (18) aufweist, die beide einen Durchmesser haben, der gleich dem Innendurchmesser des Transportrohrs (14) ist.

8. Transportvorrichtung nach einem der vorhergehenden Ansprüche, **dadurch gekennzeichnet, dass** sich der Eingabepunkt (A) auf einer Höhe über einem horizontalen Bodenniveau befindet, die vom Benutzer gut zugänglich ist, insbesondere auf Brusthöhe eines Menschen.

9. Transportvorrichtung nach einem der vorhergehenden Ansprüche, **dadurch gekennzeichnet, dass** der zweite Transferpunkt (C) horizontal neben dem Zuführpunkt (Z) angeordnet ist.

10. Transportvorrichtung gemäss einem der Ansprüche 1 bis 9, **dadurch gekennzeichnet, dass** der Eingabepunkt (A) vertikal unter oder horizontal neben dem ersten Transferpunkt (B) angeordnet ist.

11. Transportvorrichtung nach einem der vorhergehenden Ansprüche, **dadurch gekennzeichnet, dass** ein Druckgaszuführungselement (DGZE) vorgesehen ist, welches vertikal unterhalb des ersten Transferpunkts (B) angeordnet ist und einen Abstand zu diesem besitzt, der so gewählt ist, dass der erste Transportbehälter (TB1) gerade noch, vorzugsweise berührungslos, zwischen dem unteren Ende des Transportrohrs (14) und dem oberen Ende des Druckgaszuführungselementes (DGZE) Platz hat, wobei das Druckgaszuführungselement (DGZE) eine zum unteren Ende des Transportrohrs (14) gerichtete Öffnung (12) aufweist und mittels einer Druckgasleitung (8a) mit einem Druckgasgenerator (7) verbunden ist.

12. Transportvorrichtung nach Anspruch 11, **dadurch gekennzeichnet, dass** im Betriebszustand das Druckgaszuführungselement (DGZE) an der der Öffnung (12) entgegen gesetzten Seite mit der Druckgasleitung (8a) gasdicht verbunden ist.

13. Transportvorrichtung nach Anspruch 10, **dadurch gekennzeichnet, dass** eine Druckgasleitung (8a) im Betriebszustand gasdicht mit der unteren Öffnung des ersten Transportbehälters (TB1) verbunden ist.

14. Kryomagnetsystem mit einem Kryostaten (1) und einer Transportvorrichtung nach einem der vorhergehenden Ansprüche,
wobei der Kryostat (1) ein durchgehendes und vertikal verlaufendes RT-Rohr (4) zur Aufnahme des Transportgutes (18) aufweist,
wobei der Eingabepunkt (A) horizontal vom Kryostaten (1) beabstandet ist, und
wobei der Zuführungspunkt (Z) oberhalb des RT-Rohrs (4) und auf dessen Symmetrieachse liegt.

15. Kryomagnetsystem nach Anspruch 14, **dadurch gekennzeichnet, dass** ein Druckgasgenerator (7) vorgesehen ist, der mit Hilfe einer Druckgasleitung (8b) mit dem RT-Rohr (4) derart verbunden ist, dass vom Bereich des magnetischen Zentrums (3) her Druckgas zum oberen Ende (5) des RT-Rohrs (4) hin strömen kann.

16. Transportvorrichtung gemäß einem der Ansprüche 1 bis 13, **dadurch gekennzeichnet, dass** der Transportbehälter (TB2) eine obere Entlüftungsöffnung (17) und eine entgegengesetzt angeordnete untere Öffnung zur Aufnahme eines Transportgutes (18) aufweist, welches einen Probenhalter (19) und eine NMR Messprobe (20), mit einer aktivierbaren und deaktivierbaren Haltevorrichtung, die im nicht aktivierten Zustand das Herunterfallen des Transportgutes (18) verhindert und im aktivierten Zustand das Transportgut (18) freigibt, umfasst.

17. Verfahren zum Befördern eines Transportgutes (18) zwischen einem Eingabepunkt (A) und einem Zuführungspunkt (Z), an dem das Transportgut (18) einem RT-Rohr(4) des Kryostaten (1) zugeführt werden kann, mit einer Transportvorrichtung nach einem der Ansprüche 1 bis 13, wobei
• am Eingabepunkt (A) das Transportgut (18) in den ersten Transportbehälter (TB1) eingeführt wird,
• der erste Transportbehälter (TB1) vom Eingabepunkt (A) zum ersten Transferpunkt (B) bewegt wird,
• am unteren Ende des ersten Transportbehälters (TB1) eine erste Druckgaszufuhr eingeschaltet wird, wodurch das Transportgut (18) aus dem ersten Transportbehälter (TB1) gehoben und innerhalb des Transportrohrs (14) hinauf in den am zweiten Transferpunkt (C) befindlichen zweiten Trans-portbehälter befördert wird.
• das Transportgut (18) im zweiten Transportbehälter (TB2) durch Zuschalten eines Arretierbolzens (28) arretiert wird,
• die erste Druckgaszufuhr ausgeschaltet und das Transportgut (18) mit Hilfe des zweiten Transportbehälter (TB2) vom zweiten Transferpunkt (C) zum Zuführungspunkt (Z) befördert wird,
• eine zweite Druckgaszufuhr in den Bereich des magnetischen Zentrums (3) eingeschaltet wird, so dass sich im RT-Rohr (4) ein Gaskissen bildet,
• das Transportgut (18) aus dem zweiten Transportbehälter (TB2) durch Wegschalten des Arretierbolzens (28) freigegeben wird, wodurch das Transportgut (18) auf das im RT-Rohr (4) entstandene Gaskissen fällt und auf diesem so lange nach unten in einen Messraum innerhalb des RT-Rohrs befördert wird, bis es auf einem Anschlag aufliegt.

18. Verfahren nach Anspruch 17, **dadurch gekennzeichnet, dass** nach der Ankunft des Transportgutes (18) im Messraum die zweite Druckgaszufuhr ausgeschaltet und eine Magnetresonanzmessung, insbesondere NMR-Spektroskopie oder ESR, durchgeführt wird.

19. Verfahren nach Anspruch 18, **dadurch gekennzeichnet, dass** nach der Magnetresonanzmessung
• die zweite Druckgaszufuhr wieder eingeschaltet und das Transportgut (18) auf dem Gaskissen in den über dem Zuführungspunkt (Z) befindlichen zweiten Transportbehälter (TB2) zurück befördert wird,
• das Transportgut (18) im zweiten Transportbehälter (TB2) durch Zuschalten des Arretierbolzens (28) arretiert, und die zweite Druckgaszufuhr wieder ausgeschaltet wird,
• das Transportgut im zweiten Transportbehälter (TB2) vom Zuführungspunkt (Z) zurück zum zweiten Transferpunkt (C) befördert wird,
• die erste Druckgaszufuhr eingeschaltet wird, so dass sich im Transportrohr (14) ein Gaskissen bilden kann,
• das Transportgut (18) aus dem zweiten Transportbehälter (TB2) durch Wegschalten des Arretierbolzens (28) freigegeben wird, so dass das Transportgut (18) auf das Gaskissen fällt und in den am ersten Transferpunkt (B) befindlichen ersten Transportbehälter (TB1) befördert wird, und
• die erste Druckgaszufuhr wieder abgeschaltet und das im ersten Transportbehälter (TB1) befindliche Transportgut vom ersten Transferpunkt (B) wieder zurück zum Eingabepunkt (A) befördert wird.

## Claims

1. Transport device for conveying an object to be transported (18) between an input point (A), where the object to be transported (18) can be inserted into and removed from the transport device, and a supply point (Z), where the object to be transported (18) can be supplied to an RT tube (4) of a cryostat (1), wherein the object to be transported (18) comprises an NMR measuring sample (20) and a sample holder (19),
wherein the input point (A) is both horizontally and also vertically spaced apart from the supply point (Z),
wherein a transport tube (14) is provided for conveying the object to be transported within the transport tube (14) from a first transfer point (B) at the lower end of the transport tube (14) to a second transfer point (C) at the upper end of the transport tube (14), wherein the transport tube (14) is vertically arranged,
**characterized in that**
the transport tube (14) is designed for direct pneumatic conveyance of the object to be transported without the use of a carriage such that the object to be transported (18) itself acts as a piston inside the transport tube (14) and the inner circumferential surface of the transport tube (14) acts as cylinder,
a first transport container (TB1) having an upper opening for receiving the object to be transported (18) and a lower opening for supplying pressure gas and also a first transfer device for conveying the first transport container (TB1) between the input point (A) and the first transfer point (B) are provided, and
that a second transport container (TB2) is provided for receiving the object to be transported (18) and a second transfer device is disposed between the second transfer point (C) and the supply point (Z) for conveying the second transport container (TB2) between the second transfer point (C) and the supply point (Z).

2. Transport device according to claim 1, **characterized in that** the first transfer device comprises a guiding rail (FV1) along which the first transport container (TB1) can be moved.

3. Transport device according to claim 1, **characterized in that** the first transfer device comprises a pivot arm that can be rotated about an axis and is suited to receive the first transport container (TB1) and convey the first transport container from the input point (A) to the first transfer point (B) by means of a rotary motion of the pivot arm (21).

4. Transport device according to claim 1, **characterized in that** the first transfer device has a carousel (23) that can be rotated about an axis of rotation and has a plurality of first transport containers (TB1) that are disposed in a circle, the center of which is located on said axis of rotation, wherein the transport containers (TB1) can be moved from the input point (A) to the first transfer point (B) through a rotary motion of the carousel (23).

5. Transport device according to any one of the preceding claims, **characterized in that** the second transfer device has a guiding rail (FV2) along which the second transport container (TB2) can be moved.

6. Transport device according to any one of the preceding claims, **characterized in that** the transport tube (14) has a vertical symmetry axis and both the first transfer point (B) and also the second transfer point (C) are disposed on the symmetry axis of the transport tube (14).

7. Transport device according to any one of the preceding claims, **characterized in that** the first transport container (TB1) has an upper opening and that the second transport container (TB2) has a lower opening for receiving the object to be transported (18), the diameter of both of the openings being equal to the inner diameter of the transport tube (14).

8. Transport device according to any one of the preceding claims, **characterized in that** the input point (A) is located at a height above a horizontal bottom level that is easily accessible to the user, in particular, at breast level of a person.

9. Transport device according to any one of the preceding claims, **characterized in that** the second transfer point (C) is disposed horizontally next to the supply point (Z).

10. Transport device according to any one of the claims 1 through 9, **characterized in that** the input point (A) is disposed vertically below or horizontally next to the first transfer point (B).

11. Transport device according to any one of the preceding claims, **characterized in that** a pressure gas supply element (DGZE) is provided, which is disposed vertically below and at a separation from the first transfer point (B), the separation being selected such that the first transport container (TB1) just fits into the space between the lower end of the transport tube (14) and the upper end of the pressure gas supply element (DGZE), preferably in a contact-free fashion, wherein the pressure gas supply element (DGZE) has an opening (12) facing the lower end of the transport tube (14), and is connected to a pressure gas generator (7) by means of a pressure gas line (8a).

12. Transport device according to claim 11, **characterized in that**, in the operating state, the pressure gas supply element (DGZE) is connected in a gas-tight fashion to the pressure gas line (8a) on the side opposite to the opening (12).

13. Transport device according to claim 10, **characterized in that**, in the operating state, a pressure gas line (8a) is connected in a gas-tight fashion to the lower opening of the first transport container (TB1).

14. Cryomagnet system with a cryostat (1) and a transport device according to any one of the preceding claims, wherein the cryostat (1) has a continuous and vertically extending RT tube (4) for receiving the object to be transported (18),
wherein the input point (A) is horizontally spaced apart from the cryostat (1), and
wherein the supply point (Z) is located above the RT tube (4) on the symmetry axis thereof.

15. Cryomagnet system according to claim 14, **characterized in that** a pressure gas generator (7) is provided that is connected to the RT tube (4) by means of a pressure gas line (8b) in such a fashion that pressure gas can flow from the area of the magnetic center (3) to the upper end (5) of the RT tube (4).

16. Transport device according to any one of the claims 1 through 13, **characterized in that** the transport container (TB2) comprises an upper ventilation opening (17) and an oppositely disposed lower opening for receiving an object to be transported (18) comprising a sample holder (19) and an NMR measuring sample (20), with a holding device that can be activated and deactivated and prevents the object to be transported (18) from falling down in the deactivated state and releases the object to be transported (18) in the activated state.

17. Method for conveying an object to be transported (18) between an input point (A) and a supply point (Z) where the object to be transported (18) can be supplied to an RT tube (4) of the cryostat (1), with a transport device according to any one of the claims 1 through 13, wherein
- the object to be transported (18) is inserted into the first transport container (TB1) at the input point (A),
- the first transport container (TB1) is moved from the input point (A) to the first transfer point (B),
- a first pressure gas supply is switched on at the lower end of the first transport container (TB1), thereby lifting the object to be transported (18) out of the first transport container (TB1) and conveying it within the transport tube (14) in an upward direction into the second transport container, which is located at the second transfer point (C),
- the object to be transported (18) is locked in the second transport container (TB2) by locking a locking bolt (28),
- the first pressure gas supply is switched off and the object to be transported (18) is transported from the second transfer point (C) to the supply point (Z) by means of the second transport container (TB2),
- a second pressure gas supply is switched on in the area of the magnetic center (3) such that a gas cushion is formed in the RT tube (4),
- the object to be transported (18) is released from the second transport container (TB2) by unlocking the locking bolt (28), thereby dropping the object to be transported (18) onto the gas cushion formed in the RT tube (4), and transporting it on the gas cushion in a downward direction into a measuring chamber within the RT tube until is comes to rest on a stop.

18. Method according to claim 17, **characterized in that**, after arrival of the object to be transported (18) in the measuring chamber, the second pressure gas supply is switched off and magnetic resonance measurement is performed, in particular NMR spectroscopy or ESR.

19. Method according to claim 18, **characterized in that**, after the magnetic resonance measurement,
- the second pressure gas supply is switched on again and the object to be transported (18) is returned on the gas cushion into the second transport container (TB2) located above the supply point (Z),
- the object to be transported (18) is locked in the second transport container (TB2) by locking the locking bolt (28) and the second pressure gas supply is switched off again,
- the object to be transported in the second transport container (TB2) is returned from the supply point (Z) to the second transfer point (C),
- the first pressure gas supply is switched on such that a gas cushion can form in the transport tube (14),
- the object to be transported (18) is released from the second transport container (TB2) by unlocking the locking bolt (28) such that the object to be transported (18) falls onto the gas cushion and is transported into the first transport container (TB1) located at the first transfer point (B), and
- the first pressure gas supply is switched off again and the object to be transported that is located in the first transport container (TB1) is returned from the first transfer point (B) to the input point (A).

## Revendications

1. Dispositif de transport pour transporter un article à transporter (18) entre un point d'entrée (A), auquel l'article à transporter (18) peut être introduit dans le dispositif de transport et en être retiré, et un point d'amenée (Z), auquel l'article à transporter (18) peut être amené à un tube à température ambiante (4) d'un cryostat (1), l'article à transporter (18) comprenant un échantillon de mesure RMN (20) et un porte-échantillon (19),
le point d'entrée (A) étant espacé du point d'amenée (Z) aussi bien horizontalement que verticalement,
un tube de transport (14) étant prévu pour transporter l'article à transporter à l'intérieur du tube de transport (14) d'un premier point de transfert (B) à l'extrémité inférieure du tube de transport (14) vers un deuxième point de transfert (C) à l'extrémité supérieure du tube de transport (14),
le tube de transport (14) étant disposé verticalement,
**caractérisé en ce**
**que** le tube de transport (14) est conçu pour le transport pneumatique direct de l'article à transporter sans utilisation d'un chariot d'entraînement, de sorte que l'article à transporter (18) à l'intérieur du tube de transport (14) agit lui-même comme piston et la surface périphérique intérieure du tube de transport (14) comme cylindre,
**qu'**un premier récipient de transport (TB1) avec une ouverture supérieure pour recevoir l'article à transporter (18) et avec une ouverture inférieure pour l'amenée d'un gaz sous pression, et un premier dispositif de transfert pour transporter le premier récipient de transport (TB1) entre le point d'entrée (A) et le premier point de transfert (B) sont prévus, et
**qu'**un deuxième récipient de transport (TB2) est prévu pour recevoir l'article à transporter (18) et un deuxième dispositif de transfert pour transporter le deuxième récipient de transport (TB2) entre le deuxième point de transfert (C) et le point d'amenée (Z) est disposé entre le deuxième point de transfert (C) et le point d'amenée (Z).

2. Dispositif de transport selon la revendication 1, **caractérisé en ce que** le premier dispositif de transfert comprend un rail de guidage (FV1) le long duquel le premier récipient de transport (TB1) est déplaçable.

3. Dispositif de transport selon la revendication 1, **caractérisé en ce que** le premier dispositif de transfert comprend un bras pivotant pouvant tourner autour d'un axe, qui est apte à recevoir le premier récipient de transport (TB1) et à transporter le premier récipient de transport du point d'entrée (A) vers le premier point de transfert (B) au moyen d'un mouvement de rotation du bras pivotant (21).

4. Dispositif de transport selon la revendication 1, **caractérisé en ce que** le premier dispositif de transfert comprend un carrousel (23) pouvant tourner autour d'un axe de rotation, qui comprend une pluralité de premiers récipients de transport (TB1) disposé en un cercle dont le centre se trouve sur cet axe de rotation, les récipients de transport (18) pouvant être déplacés du point d'entrée (A) vers le premier point de transfert (B) par un mouvement de rotation du carrousel (23).

5. Dispositif de transport selon l'une des revendications précédentes, **caractérisé en ce que** le deuxième dispositif de transfert comprend un rail de guidage (FV2) le long duquel le deuxième récipient de transport (TB2) est déplaçable.

6. Dispositif de transport selon l'une des revendications précédentes, **caractérisé en ce que** le tube de transport (14) présente un axe de symétrie vertical et aussi bien le premier point de transfert (B) que le deuxième point de transfert (C) sont disposés sur l'axe de symétrie du tube de transport (14).

7. Dispositif de transport selon l'une des revendications précédentes, **caractérisé en ce que** le premier récipient de transport (TB1) présente une ouverture supérieure et le deuxième récipient de transport (TB2) une ouverture inférieure pour recevoir l'article à transporter (18), qui ont toutes les deux un diamètre qui est égal au diamètre intérieur du tube de transport (14).

8. Dispositif de transport selon l'une des revendications précédentes, **caractérisé en ce que** le point d'entrée (A) se trouve à une hauteur au-dessus d'un niveau de sol horizontal qui est facilement accessible par un utilisateur, en particulier à hauteur de poitrine d'une personne.

9. Dispositif de transport selon l'une des revendications précédentes, **caractérisé en ce que** le deuxième point de transfert (C) est disposé horizontalement à côté du point d'amenée (Z).

10. Dispositif de transport selon l'une des revendications 1 à 9, **caractérisé en ce que** le point d'entrée (A) est disposé verticalement au-dessous ou horizontalement à côté du premier point de transfert (B).

11. Dispositif de transport selon l'une des revendications précédentes, **caractérisé en ce qu'**un élément d'amenée de gaz sous pression (DGZE) est prévu, lequel est disposé verticalement au-dessous du premier point de transfert (B) et présente par rapport à celui-ci une distance qui est choisie de façon que le premier récipient de transport (TB1) ait tout juste, de préférence sans contact, de la place entre l'extrémité inférieure du tube de transport (14) et l'extrémité supérieure de l'élément d'amenée de gaz sous pression' (DGZE), l'élément d'amenée de gaz sous pression (DGZE) présentant une ouverture (12) dirigée vers l'extrémité inférieure du tube de transport (14) et étant reliée à un générateur de gaz sous pression (7) au moyen d'une conduite de gaz sous pression (8a).

12. Dispositif de transport selon la revendication 11, **caractérisé en ce qu'**en fonctionnement, l'élément d'amenée de gaz sous pression (DGZE) est relié de manière étanche aux gaz à la conduite de gaz sous pression (8a) du côté opposé à l'ouverture (12).

13. Dispositif de transport selon la revendication 10, **caractérisé en ce qu'**en fonctionnement, une conduite de gaz sous pression (8a) est reliée de manière étanche aux gaz à l'ouverture inférieure du premier récipient de transport (TB1).

14. Système cryomagnétique avec un cryostat (1) et un dispositif de transport selon l'une des revendications précédentes,
dans lequel le cryostat (1) présente un tube à température ambiante (4) continu et s'étendant verticalement pour recevoir l'article à transporter (18),
dans lequel le point d'entrée (A) est espacé horizontalement du cryostat (1) et
dans lequel le point d'amenée (Z) se situe au-dessus du tube à température ambiante (4) et sur son axe de symétrie.

15. Système cryomagnétique selon la revendication 14, **caractérisé en ce qu'**un générateur de gaz sous pression (7) est prévu, qui est relié au tube à température ambiante (4) à l'aide d'une conduite de gaz sous pression (8b) de telle façon que du gaz sous pression puisse passer de la région du centre magnétique (3) vers l'extrémité supérieure (5) du tube à température ambiante (4).

16. Dispositif de transport selon l'une des revendications 1 à 13, **caractérisé en ce que** le récipient de transport (TB2) présente une ouverture d'aération supérieure (17) et une ouverture inférieure disposée à l'opposé pour recevoir un article à transporter (18), lequel comprend un porte-échantillon (19) et un échantillon de mesure RMN (20), avec un dispositif de maintien activable et désactivable qui, à l'état non activé, empêche la chute de l'article à transporter (18) et, à l'état activé, libère l'article à transporter (18).

17. Procédé de transport d'un article à transporter (18) entre un point d'entrée (A) et un point d'amenée (Z) auquel l'article à transporter (18) peut être amené à un tube à température ambiante (4) du cryostat (1), avec un dispositif de transport selon l'une des revendications 1 à 13, consistant en ce que
• au point d'entrée (A), l'article à transporter (18) est introduit dans le premier récipient de transport (TB1),
• le premier récipient de transport (TB1) est déplacé du point d'entrée (A) vers le premier point de transfert (B),
• à l'extrémité inférieure du premier récipient de transport (TB1), une première amenée de gaz sous pression est activée, de sorte que l'article à transporter (18) est soulevé du premier récipient de transport (TB1) et transporté à l'intérieur du tube de transport (14) vers le deuxième récipient de transport (TB2) se trouvant au deuxième point de transfert (C),
• l'article à transporter (18) est arrêté dans le deuxième récipient de transport (TB2) par activation d'un boulon d'arrêt (28),
• la première amenée de gaz sous pression est désactivée et l'article à transporter (18) est transporté à l'aide du deuxième récipient de transport (TB2) du deuxième point de transfert (C) vers le point d'amenée (Z),
• une deuxième amenée de gaz sous pression est activée dans la région du centre magnétique (3), de sorte qu'il se forme un coussin de gaz dans le tube à température ambiante (4),
• l'article à transporter (18) est libéré du deuxième récipient de transport (TB2) par désactivation du boulon d'arrêt (28), de sorte que l'article à transporter (18) tombe sur le coussin de gaz formé dans le tube à température ambiante (4) et est descendu sur celui-ci à l'intérieur du tube à température ambiante dans une chambre de mesure jusqu'à ce qu'il repose sur une butée.

18. Procédé selon la revendication 17, **caractérisé en ce qu'**après l'arrivée de l'article à transporter (18) dans la chambre de mesure, la deuxième amenée de gaz sous pression est désactivée et une mesure de résonance magnétique, en particulier une spectroscopie RMN ou ESR, est effectuée.

19. Procédé selon la revendication 18, **caractérisé en ce qu'**après la mesure de résonance magnétique,
• la deuxième amenée de gaz sous pression est de nouveau activée et l'article à transporter (18) est retransporté sur le coussin de gaz dans le deuxième récipient de transport (TB2) se trouvant au-dessus du point d'amenée (Z),
• l'article à transporter (18) est arrêté dans le deuxième récipient de transport (TB2) par activation du boulon d'arrêt (28) et la deuxième amenée de gaz sous pression est de nouveau désactivée,
• l'article à transporter dans le deuxième récipient de transport (TB2) est retransporté du point d'amenée (Z) vers le deuxième point de transfert (C),
• la première amenée de gaz sous pression est activée, de sorte qu'un coussin de gaz peut se former dans le tube de transport (14),
• l'article à transporter (18) est libéré du deuxième récipient de transport (TB2) par désactivation du boulon d'arrêt (28), de sorte que l'article à transporter (18) tombe sur le coussin de gaz et est transporté dans le premier récipient de transport (TB1) se trouvant au premier point de transfert (B), et
• la première amenée de gaz sous pression est de nouveau désactivée et l'article à transporter se trouvant dans le premier récipient de transport (TB1) est retransporté du premier point de transfert (B) vers le point d'entrée (A).
